# DEMANDE DE BREVET EUROPEEN

(11) **EP 1 818 976 A1**
(43) Date de publication de la demande: **15.08.2007**
(21) Numéro de dépôt: 06290252.3
(22) Date de dépôt: 14.02.2006
(51) Int. Cl.: H01L 21/762

(54) **Procédé de transfert d'une couche mince formée dans un substrat présentant des amas de lacunes**

(71) Demandeur: S.O.I.Tec Silicon on Insulator Technologies, 38190 Bernin (FR)
(72) Inventeur: Maleville, Christophe, 38660 La Terrasse (FR); Neyret, Eric, 38360 Sassenage (FR)
(74) Mandataire: Collin, Jérôme

(57) **Abrégé**

L'invention concerne selon un premier aspect un procédé de fabrication d'un substrat comportant une couche mince de matériau semi-conducteur et un substrat support, la couche mince résultant du transfert sur le substrat support d'une partie d'un substrat donneur présentant des amas de lacunes à une première densité, caractérisé en ce qu'il comporte :
• après transfert de ladite partie du substrat donneur vers le substrat support, une étape de guérison des amas de lacunes présents dans la partie du substrat donneur transférée sur le substrat support pour réduire la première densité à une seconde densité,
• et avant ladite étape de guérison, une ou plusieurs étapes adaptées pour ne pas venir augmenter la taille des amas de lacunes présents dans ladite partie du substrat donneur à ladite première densité.

L'invention concerne également un substrat SeOI obtenu par ce procédé, ainsi qu'un procédé de recyclage d'un substrat présentant des amas de lacunes et ayant servi de substrat donneur à partir duquel une couche mince a été prélevée et transférée sur un substrat support.

## Description

L'invention concerne un procédé de fabrication d'un substrat par transfert d'une couche mince de matériau semi-conducteur d'un substrat donneur vers un substrat support.

Un domaine d'application de l'invention est celui des procédés de réalisation de structures semi-conducteur sur isolant (encore appelées structures SeOl selon l'acronyme de l'expression anglo-saxonne Semiconductor On Insulator), par exemple des structures silicium sur isolant (encore appelées structures SOI selon l'acronyme de l'expression Silicon On Insulator), ces structures SeOI servant de substrats pour l'électronique, l'optique et l'optoélectronique.

Les strucutures SeOi comportent ainsi une couche isolante intercalée entre une couche mince de matériau semi-conducteur et un substrat support.

Les procédés de type SMARTCUT^{®} sont un exemple de procédé de ce type. Ces procédés correspondent à un mode préféré de mise en oeuvre de l'invention.

On trouvera de plus amples détails concernant le procédé SMARTCUT^{®} dans le document « Silicon-On-Insulator Technology : Materials to VLSI, 2nd Edition » de Jean-Pierre Colinge chez « Kluwer Academic Publishers », p.50 et 51.

La réalisation par le procédé SMARTCUT^{®} d'une structure SeOl, et notamment d'une structure SeOl dans laquelle la couche mince est particulièrement fine (épaisseur typiquement inférieure à 400 nm), nécessite l'utilisation d'un substrat donneur de départ ne présentant pas de défauts de croissance sous la forme d'amas de lacunes (connus sous l'acronyme de COPs selon l'expression anglo-saxonne Crystal Originated Particules).

La présence de ces amas de lacunes dans le volume du substrat donneur peut en effet être susceptible de générer des défauts dont la taille est supérieure à l'épaisseur de la couche mince de la structure SeOl finale.

Or ces défauts dits traversants sont des défauts tueurs ; en effet, un composant formé sur l'un de ces défauts ne fonctionnera pas. La présence de ces défauts traversants est donc un paramètre qui conditionne la qualité des composants qui seront créées sur la structure finale. Il s'avère donc indispensable de limiter autant que possible la présence de ces défauts traversants.

Bien entendu, on comprend que la problématique des défauts traversants est d'autant plus importante que l'épaisseur de la couche mince est faible.

Pour limiter le nombre de défauts traversants dans un substrat SeOI, une solution couramment mise en oeuvre jusqu'à présent consiste à utiliser un substrat de départ de très bonne qualité cristallographique, présentant une densité réduite de COPs.

Les substrats de départ sont typiquement formés par découpe dans un lingot obtenu par le procédé CZ (tirage Czochralsky).

Le contrôle de la vitesse de tirage et de la vitesse de refroidissement du lingot permet de réduire la quantité de défauts de type amas de lacune. Un substrat de départ quasi-exempt de COPs est ainsi typiquement formé par découpe d'un lingot obtenu par le procédé CZ (tirage Czochralsky) selon des conditions de tirage très spécifiques, et en particulier grâce à une vitesse de tirage particulièrement lente (tirage également dénommé par l'appellation « Very Slow Pull » pour l'obtention d'un cristal quasi-parfait connu par l'homme du métier sous l'appellation « Near Perfect Crystal » du fait d'un très faible niveau de défauts).

Les substrats formés par découpe dans un lingot obtenu par des procédés de tirage plus simples et/ou plus rapides présentent comparativement plus d'amas de lacunes, et sont donc considérés comme étant incompatibles avec les contraintes imposées dans les domaines d'application visés (tels que l'optique, l'électronique ou l'optoélectronique).

A titre d'exemple, un substrat formé par découpe d'un cristal quasi-parfait (« Near Perfect Crystal ») obtenu par tirage « Very Slow Pull » à une vitesse inférieure à 0,5 mm/min présente typiquement une densité de COPs (de taille supérieure à 0,1*µ*m) comprise entre 0,045 et 0,075. COPs/cm² (soit 30 à 50 COPs de taille supérieure à 0,1*µ*m dans une plaquette de 300 mm de diamètre disposant d'une surface de 660 cm² en tenant compte d'une zone d'exclusion de 5 mm autour de la plaquette).

Comparativement, un substrat obtenu par un tirage standard à une vitesse 1,2 à 1,5 fois supérieure à celle du tirage « Very Slow Pull » présente une densité de COPs (de taille supérieure à 0,1*µ*m) comprise entre 1,5 et 4,5 COPs/cm² (soit 1000 à 3000 COPs de taille supérieure à 0,1*µ*m dans une plaquette de 300 mm de diamètre).

On notera ici que la vitesse de refroidissement du lingot lors de son tirage est également un facteur qui vient influencer sa qualité cristallographique. On pourra ainsi se rapporter au chapitré 1.6 « Si MELT GROWTH: GROWN-IN DEFECTS AND SIMULATION OF THEIR FORMATION » de W. von Ammon et E.Domberger, en pp 39-51 du document « Properties of Crystalline Silicon » édité par Robert Hull aux publications INSPEC (janvier 1998), qui met en avant le fait qu'une haute vitesse de refroidissement (tirage de type refroidissement rapide « Fast Cool ») s'accompagne d'une augmentation de la densité des défauts. Un substrat obtenu par découpe d'un lingot obtenu par tirage de type « Fast Cool » est donc lui aussi incompatible avec les contraintes imposées dans les domaines d'application de l'invention.

La production d'un substrat de départ de qualité (substrat « Near Perfect Crystal » quasi-exempt de COPs, par mise en oeuvre d'un tirage CZ « Very Slow Pull ») présente un rendement nettement inférieur à la production de substrats selon des procédés de tirage plus simples et/ou plus rapides. La production d'un tel substrat quasi-parfait par tirage « Very Slow Pull » s'avère donc particulièrement coûteuse ; son coût est ainsi typiquement 30% supérieur à celui des substrats obtenus par tirage CZ standard.

On notera qu'il a également été proposé d'utiliser comme substrat de départ dans un procédé de fabrication d'une structure SOI, un substrat standard préalablement traité thermiquement pour faire diminuer la quantité de COPs. On pourra par exemple se reporter à l'article "A NOVEL METHOD FOR ACHIEVING VERY LOW COPS IN CZ WAFERS" de J. L. Vasat et T. Torack, publiée dans le numéro de Mars 2003 de la revue Solid State Technology.

Toutefois, le recours à un tel traitement thermique préalable n'est pas satisfaisant. En effet, ce traitement vient modifier les propriétés de surface du substrat de départ (et peut en particulier venir augmenter sa rugosité de surface) de sorte que des problèmes peuvent être rencontrés lors du collage du substrat de départ à un substrat support (et notamment la dégradation de la qualité du collage). Par ailleurs, ce traitement thermique préalable peut générer des défauts de type « slip lines » (lignes de glissement) ou des précipités d'oxygène susceptibles de compromettre le recyclage du substrat de départ qui est généralement mis en oeuvre dans un procédé de type SMARTCUT^{®}.

Un but de l'invention est de réduire le prix de revient des substrats réalisés par transfert d'une couche mince de matériau semi-conducteur depuis un substrat donneur vers un substrat support, en particulier le prix de revient des substrats SeOl.

Plus spécifiquement, l'invention vise à permettre l'emploi, dans un procédé de transfert de type SMARTCUT®, de substrats de départ formés par découpe d'un lingot obtenu par un tirage CZ plus rentable que le tirage « Very Slow Pull » pour l'obtention d'un cristal quasi-parfait, tout en conservant une qualité cristalline de la couche mince qui soit compatible avec les applications envisagées, et cela sans rencontrer les problèmes de type collage ou recyclage occasionnés par la mise en oeuvre de la technique de traitement thermique préalable mentionnée ci-dessus.

A cet effet, l'invention propose, selon un premier aspect, un procédé de fabrication d'un substrat semi-conducteur sur isolant comportant une couche isolante intercalée entre une couche mince de matériau semi-conducteur et un substrat support, la couche mince résultant du transfert sur le substrat support d'une partie d'un substrat donneur présentant des amas de lacunes à une première densité, caractérisé en ce qu'il comporte :
- avant transfert de ladite partie du substrat donneur vers le substrat support, une étape de formation de la couche isolante adaptée pour ne pas venir augmenter la taille des amas de lacunes présents dans ladite partie du substrat donneur à ladite première densité,
- et après transfert, une étape de guérison des amas de lacunes présents dans la partie du substrat donneur transférée sur le substrat support pour réduire la première densité à une seconde densité.

Certains aspects préférés, mais non limitatifs, de ce procédé sont les suivants :
- l'étape de formation de la couche isolante est réalisée par oxydation thermique du substrat support ;
- l'étape de formation de la couche isolante est réalisée par dépôt d'une couche d'oxyde sur le substrat donneur et/ou sur le substrat support ;
- l'étape de guérison est réalisée immédiatement après transfert ;
- l'étape de guérison est réalisée en soumettant la structure obtenue après transfert à un recuit thermique ;
- le recuit thermique est réalisé sous atmosphère non oxydante ;
- le recuit est réalisé sous atmosphère contenant de l'hydrogène pur, de l'argon pur ou un mélange hydrogène/argon ;
- le recuit thermique est un traitement thermique rapide (RTP) ;
- le recuit thermique est réalisé en four ;
- le recuit est un recuit lissant réalisé sous atmosphère contenant de l'hydrogène et de l'acide chlorhydrique ;
- le substrat donneur est un substrat formé par découpe d'un lingot dudit matériau semiconducteur obtenu selon un tirage occasionnant des amas de lacunes dont la taille moyenne est inférieure à celle des amas présents dans un substrat quasi-parfait formé par découpe d'un lingot obtenu selon un tirage à faible vitesse ;
- le substrat donneur est formé par découpe d'un lingot obtenu selon un tirage CZ occasionnant une densité d'amas de lacunes, dont la taille est supérieure à 0,14 µm, inférieure à 0,01/cm² ;
- il comporte une étape préalable de préparation du substrat donneur comprenant les opérations :
   - de fabrication d'un lingot dudit matériau semiconducteur selon un tirage occasionnant des amas de lacunes dont la taille moyenne est inférieure à celle des amas présents dans un substrat quasi-parfait formé par découpe d'un lingot obtenu selon un tirage à faible vitesse ;
   - et de découpe du substrat donneur dans ce lingot ;
- le substrat donneur est formé par découpe d'un lingot obtenu selon un tirage CZ occasionnant une densité d'amas de lacunes, dont la taille est inférieure à 0,2 *µ*m, supérieure à 1,5/cm² ;
- le substrat donneur est formé par découpe d'un lingot obtenu selon un tirage CZ occasionnant une densité d'amas de lacunes, dont la taille est inférieure à 0,12 *µ*m, supérieure à 3/cm² ;
- le substrat donneur est formé par découpe d'un lingot obtenu selon un procédé CZ par tirage à une vitesse au moins 1,2 fois supérieure à celle dudit tirage à faible vitesse pour l'obtention d'un cristal quasi-parfait ;
- le substrat donneur est formé par découpe d'un lingot ayant subi un refroidissement rapide ;
- le substrat donneur est un substrat formé par découpe d'un lingot ayant été soumis à un dopage azote ;
- il comporte une étape consistant à créer une zone de fragilisation dans l'épaisseur du substrat donneur sans que ledit substrat donneur n'ait été préalablement soumis à un traitement de nettoyage ;
- il comporte, préalablement à l'étape de création d'une zone de fragilisation, une étape consistant à déposer une couche d'oxyde en surface du substrat donneur pour former une couche de protection, ladite couche de protection pouvant être retirée une fois la zone de fragilisation créée ;
- le substrat donneur est en silicium ;
- le substrat support est obtenu de la même manière que le substrat donneur.

Selon un autre aspect, l'invention concerne un substrat semi-conducteur sur isolant comportant une couche isolante intercalée entre une couche mince de matériau semi-conducteur et un substrat support, obtenu par le procédé selon le premier aspect de l'invention, et notamment un substrat SeOl obtenu à partir d'un substrat donneur présentant une densité d'amas de lacunes sensiblement égale à 3/cm², caractérisé en ce que la couche mince comporte au final une densité d'amas de lacunes sensiblement inférieure ou égale à 0,075/cm².

Selon encore un autre aspect, l'invention concerne un procédé de fabrication d'un substrat d'un substrat comportant une couche mince de matériau semi-conducteur et un substrat support, la couche mince résultant du transfert sur le substrat support d'une partie d'un substrat donneur présentant des amas de lacunes à une première densité, caractérisé en ce qu'il comporte :
- après transfert de ladite partie du substrat donneur vers le substrat support, une étape de guérison des amas de lacunes présents dans la partie du substrat donneur transférée sur le substrat support pour réduire la première densité à une seconde densité,
- et avant ladite étape de guérison, une ou plusieurs étapes adaptées pour ne pas venir augmenter la taille des amas de lacunes présents dans ladite partie du substrat donneur à ladite première densité.

Selon encore un autre aspect, l'invention concerne un procédé de recyclage d'un substrat présentant des amas de lacunes et ayant servi de substrat donneur à partir duquel une couche mince a été prélevée et transférée sur un substrat support, caractérisé en ce qu'il consiste en une ou plusieurs étapes adaptées pour ne pas venir augmenter la taille des amas de lacunes présents dans ledit substrat.

D'autres aspects, buts et avantages de la présente invention apparaîtront mieux à la lecture de la description détaillée suivante de formes de réalisation préférées de celle-ci, donnée à titre d'exemple non limitatif et faite en référence aux dessins annexés, sur lesquels :
- la figure 1 représente l'évolution de la taille et de la densité des COPs en fonction de la vitesse de tirage d'un lingot ;
- la figure 2 représente la guérison des COPs lors de la mise en oeuvre d'un mode de réalisation possible du procédé selon l'invention.

L'invention vise un procédé de fabrication d'un substrat comportant une couche mince de matériau semi-conducteur et un substrat support, la couche mince résultant du transfert sur le substrat support d'une partie d'un substrat donneur présentant des amas de lacunes à une première densité

Un mode de réalisation préféré de l'invention concerne plus particulièrement un procédé de transfert de type SMARTCUT^{®}, dont on rappelle ci-après les principales étapes.

Un substrat donneur en matériau semi-conducteur à partir duquel la couche mince est formée est exposé à une implantation d'espèces permettant de créer une zone de fragilisation dans l'épaisseur du substrat donneur. La face du substrat donneur ayant subie l'implantation est alors mise en contact intime avec le substrat support. Le substrat donneur est ensuite détaché au niveau de la zone de fragilisation, une partie du substrat donneur étant ainsi transférée sur le substrat support pour former la couche mince sur celui-ci.

Dans le cadre de la fabrication d'une structure SeOl, une couche isolante est intercalée entre la couche mince et le substrat support.

Dans le cadre de l'invention, le substrat donneur n'est pas nécessairement formé par découpe d'un lingot présentant une qualité cristallographique quasi-parfaite de type « Near Perfect Crystal » et obtenu par tirage CZ « Very Slow Pull ».

Au contraire, dans le cadre d'un mode de réalisation avantageux du procédé selon l'invention pour le transfert d'une couche mince d'un substrat donneur vers un substrat support, le substrat donneur est formé par découpe d'un lingot de matériau semiconducteur obtenu selon un tirage occasionnant des amas de lacunes dont la taille moyenne est inférieure à celle des amas présents dans un substrat quasi-parfait formé par découpe d'un lingot obtenu par un tirage à faible vitesse.

Selon un mode de réalisation possible, le procédé selon l'invention comporte une étape préalable de préparation du substrat donneur comprenant une opération de fabrication d'un lingot de matériau semiconducteur selon un tirage occasionnant des amas de lacunes dont la taille moyenne est inférieure à celle des amas présents dans un cristal quasi-parfait obtenu par un tirage à faible vitesse, ainsi qu'une étape visant à découper le substrat donneur dans ce lingot.

Le mode de tirage évoqué ci-dessus présente l'avantage d'être peu coûteux, tout du moins en comparaison avec le tirage « Very Slow Pull » à faible vitesse.

A titre d'exemples, un tel mode de tirage est par exemple un tirage CZ réalisé à vitesse rapide ou à refroidissement rapide permettant d'obtenir un cristal communément désigné par l'appellation « Low Defect Crystal », ou encore un cristal communément désigné par l'appellation « Standard Crystal ».

Selon un mode de réalisation avantageux du procédé selon l'invention, un dopage azote peut être réalisé lors du tirage du lingot à partir duquel le substrat donneur est obtenu. Un tel dopage azote est en effet susceptible de faciliter l'étape de guérison (qui sera détaillée par la suite) permettant de débarrasser la couche mince transférée des COPs. On pourra se reporter par exemple à l'article « GROWN-IN DEFECTS IN NITROGEN-DOPED CZOCHRALSKI SILICON » de X.YU, D.YANG, X.MA, J.YANG, L.Li and D.QUE publié en Juillet 2002 dans le volume 92, numéro 1 de la revue « Journal Of Applied Physics », dans lequel il est fait état de ce qu'un dopage azote du lingot permet de générer des COPs (certes en plus grande densité) de taille plus réduite, susceptibles de pouvoir être plus facilement traités thermiquement.

De manière préférentielle, le dopage azote réalisé lors du tirage du lingot est adapté pour introduire entre 10¹⁴ et 5.10¹⁵ atomes d'azote/cm³.

Selon un mode de réalisation avantageux de l'invention, le substrat support est également préparé de la manière indiquée ci-dessus pour le substrat donneur, notamment par découpe d'un lingot formé par tirage CZ standard. Le substrat support peut également être soumis à un dopage azote.

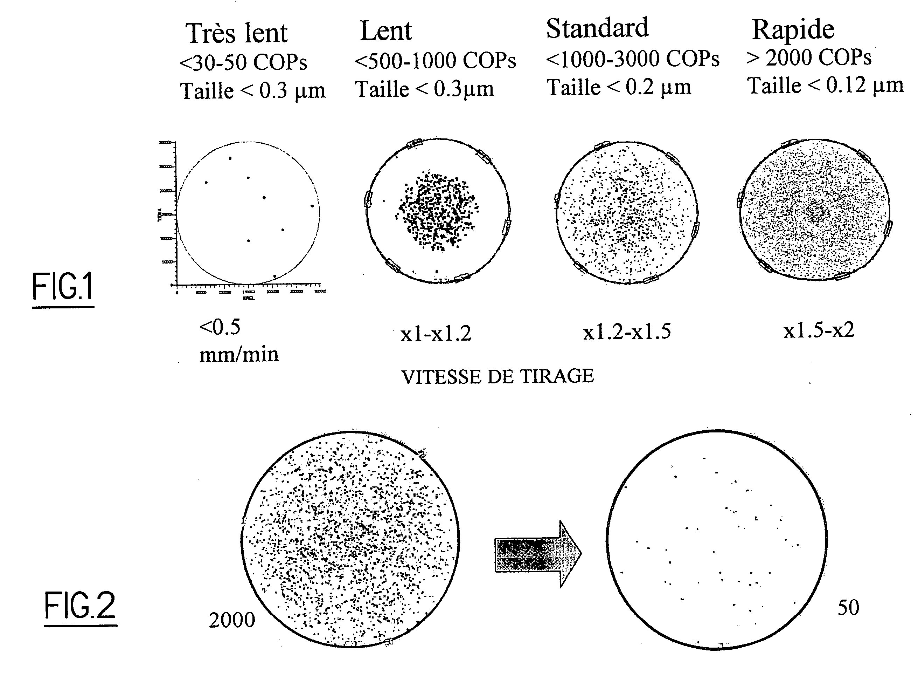

En référence à la figure 1, on a représenté l'évolution de la taille des COPs ainsi que l'évolution de la densité des COPs en fonction de la vitesse de tirage d'un lingot de matériau semi-conducteur selon le procédé CZ.

Les données relatives au nombre de COPS et à leur taille qui sont présentées sur cette figure ont été obtenues à l'aide de l'outil Surfscan SP1 de la société KLA-Tencor permettant l'inspection laser de plaquette, et notamment le recensement des COPs de taille supérieure à 0,1 µm dans une épaisseur comprise jusqu'à 5000 Angstrom sous la surface d'une plaquette de 300 mm de diamètre.

Comme cela est apparent sur la figure 1, la densité des COPs augmente avec la vitesse de tirage, alors que leur taille diminue avec la vitesse de tirage.

Ainsi, un substrat obtenu par tirage « Very Slow Pull », à une vitesse inférieure à 0,5 mm/min présente une densité de COPs, dont la taille est entre 0,1 *µ*m et 0,3 *µ*m, sensiblement comprise entre 0,045 et 0,075 COPs/cm² (soit 30 à 50 COPs dont la taille est comprise entre 0,1 *µ*m et 0,3 *µ*m pour une plaquette de 300 mm de diamètre).

Il s'agit là du substrat à qualité cristallographique quasi-parfaite (« Near Perfect Crystal ») qui est classiquement utilisé pour servir de substrat donneur dans un procédé de type SMARTCUT^{®}.

Un substrat obtenu par tirage « Slow Pull » à une vitesse 1 à 1,2 fois supérieure à celle du tirage « Very Slow Pull » présente une densité de COPs, dont la taille est entre 0,1 *µ*m et 0,3 *µ*m, sensiblement comprise entre 0,75 et 1,5 COPs/cm² (soit 500 à 1000 COPs dont la taille est comprise entre 0,1 *µ*m et 0,3 *µ*m pour une plaquette de 300 mm de diamètre).

Un substrat obtenu par tirage « Standard» à une vitesse 1,2 à 1,5 fois supérieure à celle du tirage « Very Slow Pull » présente une densité de COPs, dont la taille est entre 0,1 *µ*m et 0,2 *µ*m, sensiblement comprise entre 1,5 et 4,5 COPs/cm² (soit 1000 à 3000 COPs dont la taille est comprise entre 0,1 *µ*m et 0,2 *µ*m pour une plaquette de 300 mm de diamètre).

Enfin, un substrat obtenu par tirage « Fast Pull» à une vitesse 1,5 à 2 fois supérieure à celle du tirage « Very Slow Pull » présente une densité de COPs, dont la taille est entre 0,1 *µ*m et 0,12 *µ*m, sensiblement supérieure à 3 COPs/cm² (soit plus de 2000 COPs dont la taille est comprise entre 0,1 *µ*m et 0,12 *µ*m pour une plaquette de 300 mm de diamètre).

Ainsi, de manière schématique, un substrat découpé dans un lingot obtenu par tirage standard voire rapide (de type « Fast Pull ») présente une forte densité de petits COPs, là où un substrat découpé dans un lingot obtenu par tirage lent (de type « Slow Pull ») voire très lent (« Very Slow Pull ») présente une faible densité de gros COPs. Le contrôle de la vitesse de tirage permet ainsi de contrôler la taille et la densité des COPs.

De manière similaire au contrôle de la vitesse de tirage, le contrôle de la vitesse de refroidissement du lingot permet également de contrôler la taille et la densité des COPs. Ainsi, et comme cela est mis en avant dans le document « Si MELT GROWTH : GROWN-IN DEFECTS AND SIMULATION OF THEIR FORMATION » déjà discuté précédemment, le refroidissement rapide d'un lingot diminue la taille des défauts mais accroît la densité des défauts. Typiquement, on entend par refroidissement rapide, un refroidissement du lingot au cours duquel on minimise la durée du refroidissement entre 1100 et 800 °C.

Dans la suite de la description, on prendra comme exemple de tirage occasionnant des amas de lacunes dont la taille moyenne est inférieure à celle des amas présents dans un cristal quasi-parfait (tel que par exemple obtenu par le tirage de type « Fast Pull »). On comprendra que l'invention n'est pas limitée à ce mode de tirage mais s'étend à tout mode de tirage, et avantageusement à tout mode de tirage (pour l'obtention d'un substrat présentant certes un nombre négligeable de COPs mais) plus économique que le tirage pour l'obtention d'un substrat cristallographiquement quasi-parfait.

Ainsi la préparation du substrat support par tirage CZ « Fast Pull », de coût nettement réduit par rapport à un tirage « Very Slow Pull », permet de disposer d'un substrat de départ présentant une forte densité de petits COPs.

Lorsque le substrat donneur est réalisé par un procédé CZ à haute vitesse de type « Fast Pull » (et par opposition au tirage spécifique « Very Slow Pull » à faible vitesse), et sous réserve que ledit substrat donneur n'est pas soumis, avant transfert de la couche mince, à une étape susceptible de venir augmenter la taille des COPs, la couche mince ne présente pas, immédiatement après transfert sur le substrat support, des COPs susceptibles de générer des défauts traversants.

En effet, en raison du tirage de type « Fast Pull », le substrat donneur ne présente que des COPs de petite taille (certes en grande densité) non susceptibles de venir traverser l'entière épaisseur de la couche mince transférée.

Toutefois, certaines opérations classiquement réalisées dans un procédé de transfert de type SMARTCUT^{®} sont susceptibles de faire croître la taille des COPs, entraînant ainsi la formation de défauts traversants. A titre d'exemples, une oxydation, un nettoyage basique, un polissage agissent sur les COPs et en augmentent la taille, en particulier par attaque des parois des COPs dans toutes les directions.

Lorsque le procédé SMARTCUT^{®} est classiquement mis en oeuvre pour fabriquer un substrat SeOl, le substrat donneur est typiquement soumis à une oxydation thermique avant d'être exposé à l'implantation d'espèces pour former la couche isolante intercalée après transfert entre la couche mince et le substrat support (couche généralement désignée sous l'appellation de couche d'oxyde enterrée).

L'étape d'oxydation du substrat donneur consomme de la matière en surface du substrat donneur, mais aussi sur les parois des COPs. La taille des COPs est alors augmentée, et cela du même ordre de grandeur que l'épaisseur d'oxyde réalisée.

Par ailleurs, dans sa consommation de matière, l'oxydation thermique présente un effet d'intégration des COPs de volume qui sont alors reportés en surface.

Ainsi, dans le cadre d'une réalisation classique d'un substrat SeOI, du fait de l'oxydation thermique avant transfert du substrat donneur, la taille des COPs est susceptible d'augmenter, engendrant ainsi des défauts traversants après transfert.

En revanche, comme cela a déjà été mentionné précédemment, du fait du tirage « Fast Pull » ne générant que des COPs de petite taille (ou plus précisément générant une densité de COPs de taille supérieure à environ 0.14 µm inférieure à 0,01/cm², soit uniquement quelques COPs de taille supérieure à 0,14 µm pour une plaquette de 300mm), en absence d'oxydation du substrat donneur avant transfert (ou plus généralement de mise en oeuvre avant transfert de toute opération susceptible d'augmenter la taille des COPs), les COPs ne présentent généralement pas, immédiatement après transfert, une taille susceptible de former un défaut traversant.

Dans le cadre de la fabrication d'un substrat SeOl selon l'invention, et afin d'éviter la formation de défauts traversants, la couche isolante enterrée n'est pas formée de la manière classique évoquée ci-dessus en soumettant le substrat donneur à une oxydation thermique.

Le procédé selon l'invention comporte ainsi, avant transfert, une étape de formation de la couche isolante adaptée pour ne pas augmenter la taille des amas de lacunes présents dans ladite couche mince.

En d'autres termes, le substrat donneur présente des amas de lacunes à une première densité et l'étape de formation de la couche isolante réalisée avant le transfert d'une partie du substrat donneur vers le substrat support pour y former la couche mince est adaptée pour ne pas venir augmenter la taille des amas de lacunes présents dans ladite partie du substrat donneur à ladite première densité.

Selon un premier mode de réalisation possible, la couche isolante enterrée est formée en soumettant à une oxydation thermique (classiquement connue en soi) non pas le substrat donneur mais le substrat support.

Selon un deuxième mode de réalisation possible, la couche isolante est formée par dépôt d'une couche d'oxyde sur le substrat donneur et/ou sur le substrat support.

Un tel dépôt peut par exemple être réalisé selon la technique LPCVD (acronyme de l'expression anglo-saxonne Low Pressure Chemical Vapor Déposition pour Dépôt Chimique en Phase Vapeur Basse Pression), par exemple à basse température sous une atmosphère contenant le précurseur TEOS (tetraethylorthosilicate Si(OC₂H₅)₄), ou encore à haute température (procédé HTO selon l'acronyme de High Température Oxyde) sous une atmosphère contenant du silane et de l'oxygène.

Un tel dépôt peut également être réalisé selon la technique PECVD (acronyme de l'expression anglo-saxonne Plasma Enhanced Chemical Vapor Deposition pour Dépôt Chimique en Phase Vapeur Amélioré par Plasma), qui peut être mise en oeuvre à plus basse température que la technique LPCVD.

Revenant à la description générale du procédé de transfert de type SMARTCUT^{®} selon le mode de réalisation préféré de l'invention, le substrat support est exposé à une implantation d'espèces adaptée pour créer une zone de fragilisation dans son volume.

On notera que dans le cas où une couche d'oxyde est déposée sur le substrat donneur pour former la couche isolante de la structure finale, cette implantation d'espèces est réalisée au travers de ladite couche d'oxyde déposée sur le substrat donneur.

Par ailleurs, une telle couche d'oxyde déposée en surface du substrat donneur est susceptible d'agir comme couche de protection permettant de protéger la surface du substrat donneur subissant l'implantation.

Selon un mode de réalisation possible, une telle couche d'oxyde est ainsi déposée, avant implantation, sur le substrat donneur, pour agir comme couche de protection, puis est retirée après implantation avant mise en contact des substrats donneur et support (dans un tel cas de figure, la couche isolante enterrée peut alors être par exemple formée par oxydation du substrat support, ou encore par dépôt d'une nouvelle couche d'oxyde sur le substrat donneur).

De manière préférentielle, le substrat donneur n'est pas soumis à une étape de nettoyage avant implantation. En effet, comme on l'a vu précédemment (et de manière similaire à une étape d'oxydation thermique d'un substrat donneur formé par tirage Fast Pull), un tel nettoyage est susceptible de venir augmenter la taille des COPs et d'engendrer ainsi des défauts traversants.

En variante au mode de réalisation possible de l'invention décrit précédemment, d'autres techniques d'implantation (par exemple, comme cela a été présenté dans la demande PCT de brevet déposée par le présent déposant le 21/09/2004 sous le numéro IB2004003300 et non encore publiée, co-implantation de plusieurs espèces, implantation par plasma) et/ou d'autres techniques de transfert d'une couche mince peuvent être utilisées.

Par ailleurs, la quasi absence de COPs de grande taille (typiquement supérieure à environ 0,14 µm) permet de réaliser le transfert de couches sans défauts qui sont plus minces que celles qui peuvent traditionnellement être transférées (lorsque le substrat donneur présente des défauts de grande taille). En effet, la présence de défauts « traversants » dans la couche mince, c'est à dire des trous atteignant la couche d'oxyde enterré, est directement lié à la taille des COPS dans le substrat donneur.

Ainsi dans le cadre de la présente invention, les paramètres de l'implantation peuvent être réglés de manière à transférer des couches d'environ 0,15 *µ*m ou plus.

Revenant à la description d'un mode de réalisation possible de l'invention, les substrats donneur et support sont ensuite mis en contact intime, puis le substrat donneur est détaché au niveau de la zone de fragilisation. Une partie du substrat donneur est alors transférée sur le substrat support pour former la couche mince sur celui-ci.

Afin de faciliter le collage, on pourra appliquer un traitement plasma d'activation à l'une et/ou l'autre des faces des substrats mis en contact. Cela est en particulier avantageux dans le cas où la zone de fracture est obtenue par co-implantation, ce qui peut conduire dans certaines situations à rendre plus sensible l'étape de collage.

On précise ici qu'un traitement visant à nettoyer les faces des substrats donneur et support peut être mis en oeuvre avant la mise en contact intime de manière à renforcer l'énergie de cottage.

Toutefois, un tel traitement de nettoyage est adapté dans le cadre de l'invention pour ne réaliser qu'une gravure réduite des faces traitées, et n'avoir donc qu'un impact limité sur les COPs.

Le nettoyage peut être réalisé par un traitement chimique de surface de type nettoyage humide RCA. L'agressivité de ce traitement RCA peut effectivement être contrôlée pour ne réaliser qu'une gravure réduite, par exemple en surveillant la température du bain chimique, le temps d'exposition ou encore la concentration des produits.

On mentionne en particulier que la vitesse de gravure des faces soumises à un traitement de nettoyage est limitée (quelques Angstrom par minute) et qu'à ce titre, le traitement de nettoyage peut donc être adapté pour ne provoquer qu'une gravure réduite.

Le procédé selon l'invention comporte en outre, après transfert, une étape de guérison des amas de lacunes (ou COPs) présents dans la couche mince transférée pour réduire la première densité à une seconde densité.

Cette étape de guérison est de préférence mise en oeuvre immédiatement après transfert, et en tout état de cause de préférence avant toute opération susceptible d'agrandir la taille des COPs (telle qu'une oxydation sacrificielle de la couche mince par exemple).

Selon un mode de réalisation possible, cette étape de guérison est mise en oeuvre en réalisant un recuit thermique de la structure obtenue après transfert.

Cette étape permet de guérir la couche mince transférée du substrat donneur au substrat support des petits COPs. La guérison des COPs présents dans une couche dont l'épaisseur peut atteindre jusqu'à 5 µm est effectivement possible en réalisant un recuit, par exemple sous atmosphère non oxydante. La forte mobilité des atomes interstitiels présents dans le volume de la couche permet une reconstruction du cristal au niveau des COPs qui se trouvent ainsi éliminés.

A titre d'exemples, ce recuit sous atmosphère non oxydante (par exemple sous atmosphère neutre et/ou réductrice, en particulier sous atmosphère comprenant de l'argon et/ou de l'hydrogène) de la structure obtenue après détachement peut être un recuit haute température RTP (acronyme de l'expression anglo-saxonne Rapid Thermal Processing désignant un Traitement Thermique Rapide) selon lequel la structure obtenue après transfert est traitée thermiquement individuellement, ou encore un recuit thermique réalisé dans un four selon lequel différentes structures sont traitées en lot.

Le recuit RTP peut être un recuit de type RTA (acronyme de l'expression anglo-saxonne Rapid Treatment Annealing pour Recuit Thermique Rapide) réalisé sous une atmosphère contenant de l'hydrogène pur, de l'argon pur, ou encore un mélange hydrogène/argon. La température du recuit est typiquement comprise entre 1050 et 1250°C, et la durée du recuit est typiquement inférieure à 60 secondes.

Le recuit en four peut être réalisé à une température comprise entre 900°C et 1200°C, pendant plusieurs heures, sous une atmosphère contenant de l'hydrogène pur, de l'argon pur, ou encore un mélange hydrogène/argon.

Encore un autre exemple de recuit thermique est un recuit lissant réalisé sous une atmosphère contenant de l'hydrogène et de l'acide chlorhydrique, tel que présenté par exemple dans le document US2002090818. Un tel recuit lissant peut être un recuit rapide de type RTA, ou de type équipement d'épitaxie (durée comprise entre quelques secondes et quelques minutes), la structure obtenue après détachement étant alors traitée individuellement. Le recuit lissant peut également être réalisé en four (durée de l'ordre de quelques heures), différentes structures étant alors traitées en lot.

Le budget thermique de cette guérison par recuit thermique (c'est-à-dire notamment la durée et la température du recuit) est adapté en fonction du type de recuit sélectionné, de la taille des COPs (qui comme on l'a vu précédemment dépend notamment de la vitesse de tirage, et de la vitesse de refroidissement), de l'épaisseur de la couche mince, et de la mise en oeuvre ou non d'un dopage azote. On notera que le recuit de guérison est d'autant plus efficace que les COPs sont de taille réduite.

On notera par ailleurs que ces recuits ont également un effet lissant sur la surface de la couche mince (et cela par reconstruction du cristal sur une surface lisse, non oxydée).

Suite à cette étape de recuit thermique, la densité de COPs dans la couche mince est donc fortement diminuée.

En référence à la figure 2, on a représenté à gauche une couche mince transférée vers un substrat donneur, depuis un substrat de départ du type obtenu par tirage « Fast Pull » comportant environ 2000 COPs (« première densité »). Suite à l'étape de guérison, la couche mince (représentée à droite) ne présente plus qu'une cinquantaine de défauts («deuxième densité »), soit 40 fois moins.

Suite à l'étape de guérison des COPs, les étapes de type oxydation, gravure, polissage peuvent alors être mises en oeuvre, comme cela est classiquement le cas dans un procédé de transfert de type SMARTCUT^{®}.

On notera par ailleurs que l'étape de recuit thermique adaptée pour guérir les COPs présente un budget thermique tel que ladite étape est également apte à renforcer l'interface de collage entre la couche mince et le substrat support.

Un avantage reconnu d'un procédé de transfert de type SMARTCUT^{®} est la possibilité de recycler le substrat donneur, soit pour former un nouveau substrat donneur à partir duquel une nouvelle couche active sera formée et transférée, soit pour constituer un nouveau substrat support.

Dans le cadre de la présente invention, le procédé peut comprendre une étape de traitement du substrat donneur, après transfert de la couche mince sur le substrat support, adaptée pour permettre le recyclage du substrat (c'est-à-dire sa réutilisation dans le procédé de transfert).

Selon un premier mode de réalisation, cette étape de traitement est adaptée pour permettre le recyclage du substrat donneur pour qu'il puisse servir de nouveau comme substrat donneur. Cette étape de traitement permet de restituer un état de surface compatible avec un nouveau prélèvement d'une couche mince, et est réalisée sans mettre en oeuvre d'opérations susceptibles de venir augmenter la taille des amas de lacunes présents dans ce substrat. Par exemple, cette étape de traitement peut comprendre des opérations de polissage (CMP) et/ou de nettoyage adaptées, de manière similaire au traitement de nettoyage pré-collage mentionné précédemment, pour n'avoir qu'un impact limité sur les COPs, par exemple en limitant l'action des produits chimiques employés

Selon un second mode de réalisation, l'étape de traitement est adaptée pour permettre le recyclage du substrat donneur pour qu'il puisse servir de substrat support dans la fabrication d'un nouveau substrat semi-conducteur sur isolant. L'étape de traitement est dans ce cas de figure prévue pour restituer un état de surface compatible avec le collage moléculaire (qui nécessite typiquement une rugosité de surface inférieure à 5 angströms RMS).

Lors de cette étape de traitement de recyclage, l'enlèvement de matière dans l'épaisseur du substrat recyclé doit être limité à moins de 10 microns afin que l'épaisseur de la plaque de SeOI final (après recyclage) reste dans les gammes d'épaisseur imposées (typiquement de +/10 microns pour une plaque de 775 microns).

Dans le cadre de ce second mode de réalisation, une plus grande liberté est offerte quant au choix des opérations pouvant être réalisées au cours du traitement de recyclage. En effet, la taille et la densité des COPs dans le substrat support n'ont qu'un impact limité sur la qualité du substrat SeOl final. Il est donc possible d'utiliser des substrats présentant une densité de COPs équivalente, voire supérieure à la densité de COPs dans le substrat initial (par exemple plus de 1,5 COP/cm², voire plus de 3 COP/cm² ; ce qui pour une plaquette de 300 mm, se traduit par un nombre de COPs pouvant être respectivement supérieur à 1000, voire même supérieur à 2000).

Bien entendu, la présente invention n'est nullement limitée aux formes de réalisation décrites et représentées, mais l'homme du métier saura y apporter de nombreuses variantes ou modifications.

En particulier, dans le cadre de la fabrication d'un substrat SOI, le substrat donneur est bien entendu formé par découpe d'un lingot de silicium.

Par ailleurs, l'invention n'est pas limitée au procédé de tirage CZ mais s'étend à tout type de procédé de tirage de lingot.

On comprendra enfin que l'invention n'est aucunement limitée à un diamètre de plaque donné, mais concerne les plaques de tout diamètre.

## Revendications

1. Procédé de fabrication d'un substrat semi-conducteur sur isolant comportant une couche isolante intercalée entre une couche mince de matériau semi-conducteur et un substrat support, la couche mince résultant du transfert sur le substrat support d'une partie d'un substrat donneur présentant des amas de lacunes à une première densité, **caractérisé en ce qu'**il comporte :
• avant transfert de ladite partie du substrat donneur vers le substrat support, une étape de formation de la couche isolante adaptée pour ne pas venir augmenter la taille des amas de lacunes présents dans ladite partie du substrat donneur à ladite première densité,
• et après transfert, une étape de guérison des amas de lacunes présents dans la partie du substrat donneur transférée sur le substrat support pour réduire la première densité à une seconde densité.

2. Procédé selon la revendication 1, **caractérisé en ce que** l'étape de formation de la couche isolante est réalisée par oxydation thermique du substrat support.

3. Procédé selon la revendication 1, **caractérisé en ce que** l'étape de formation de la couche isolante est réalisée par dépôt d'une couche d'oxyde sur le substrat donneur et/ou sur le substrat support.

4. Procédé selon l'une des revendications précédentes, **caractérisé en ce que** l'étape de guérison est réalisée immédiatement après transfert.

5. Procédé selon l'une des revendications précédentes, **caractérisé en ce que** l'étape de guérison des amas de lacunes est réalisée en soumettant la structure obtenue après transfert à un recuit thermique.

6. Procédé selon la revendication précédente, **caractérisé en ce que** le recuit thermique est réalisé sous atmosphère non oxydante.

7. Procédé selon la revendication 6, **caractérisé en ce que** le recuit thermique est un traitement thermique rapide (RTP).

8. Procédé selon la revendication 6, **caractérisé en ce que** le recuit thermique est réalisé en four.

9. Procédé selon l'une des revendications 6 à 8, **caractérisé en ce que** le recuit est réalisé sous atmosphère contenant de l'hydrogène pur, de l'argon pur ou un mélange hydrogène/argon.

10. Procédé selon l'une des revendications 6 à 8, **caractérisé en ce que** le recuit est un recuit lissant réalisé sous atmosphère contenant de l'hydrogène et de l'acide chlorhydrique.

11. Procédé selon l'une quelconque des revendications 1 à 10, **caractérisé en ce que** le substrat donneur est un substrat formé par découpe d'un lingot dudit matériau semiconducteur obtenu selon un tirage occasionnant des amas de lacunes dont la taille moyenne est inférieure à celle des amas présents dans un substrat quasi-parfait formé par découpe d'un lingot obtenu selon un tirage à faible vitesse.

12. Procédé selon l'une des revendications 11, **caractérisé en ce que** le substrat donneur est formé par découpe d'un lingot obtenu selon un tirage CZ occasionnant une densité d'amas de lacunes, dont la taille est supérieure à 0,14 µm, inférieure à 0,01/cm².

13. Procédé selon l'une quelconque des revendications 1 à 10, **caractérisé en ce qu'**il comporte une étape préalable de préparation du substrat donneur comprenant les opérations :
- de fabrication d'un lingot dudit matériau semiconducteur selon un tirage occasionnant des amas de lacunes dont la taille moyenne est inférieure à celle des amas présents dans un substrat quasi-parfait formé par découpe d'un lingot obtenu selon un tirage à faible vitesse ;
- et de découpe du substrat donneur dans ce lingot.

14. Procédé selon l'une quelconque des revendications 11 à 13, **caractérisé en ce que** le substrat donneur est formé par découpe d'un lingot obtenu selon un tirage CZ occasionnant une densité d'amas de lacunes, dont la taille est inférieure à 0,2 µm, supérieure à 1,5/cm².

15. Procédé selon l'une quelconque des revendications 11 à 14, **caractérisé en ce que** le substrat donneur est formé par découpe d'un lingot obtenu selon un tirage CZ occasionnant une densité d'amas de lacunes, dont la taille est inférieure à 0,12 *µ*m, supérieure à 3/cm².

16. Procédé selon l'une quelconque des revendications 11 à 15, **caractérisé en ce que** le substrat donneur est formé par découpe d'un lingot obtenu selon un procédé CZ par tirage à une vitesse au moins 1,2 fois supérieure à celle dudit tirage à faible vitesse pour l'obtention d'un cristal quasi-parfait.

17. Procédé selon l'une quelconque des revendications 11 à 16, **caractérisé en ce que** le substrat donneur est formé par découpe d'un lingot ayant subi un refroidissement rapide.

18. Procédé selon l'une des revendications 11 à 17, **caractérisé en ce que** le substrat donneur est un substrat formé par découpe d'un lingot ayant été soumis à un dopage azote.

19. Procédé selon l'une des revendications précédentes, **caractérisé en ce qu'**il comporte une étape consistant à créer une zone de fragilisation dans l'épaisseur du substrat donneur sans que ledit substrat donneur n'ait été préalablement soumis à un traitement de nettoyage.

20. Procédé selon la revendication précédente, **caractérisé en ce qu'**il comporte, préalablement à l'étape de création d'une zone de fragilisation, une étape consistant à déposer une couche d'oxyde en surface du substrat donneur pour former une couche de protection, ladite couche de protection pouvant être retirée une fois la zone de fragilisation créée.

21. Procédé selon l'une quelconque des revendications précédentes, **caractérisé en ce que** le substrat donneur est en silicium.

22. Procédé selon l'une quelconque des revendications précédentes, **caractérisé en ce que** le substrat support est obtenu de la même manière que le substrat donneur.

23. Procédé de fabrication d'un substrat comportant une couche mince de matériau semi-conducteur et un substrat support, la couche mince résultant du transfert sur le substrat support d'une partie d'un substrat donneur présentant des amas de lacunes à une première densité, **caractérisé en ce qu'**il comporte :
• après transfert de ladite partie du substrat donneur vers le substrat support, une étape de guérison des amas de lacunes présents dans la partie du substrat donneur transférée sur le substrat support pour réduire la première densité à une seconde densité,
• et avant ladite étape de guérison, une ou plusieurs étapes adaptées pour ne pas venir augmenter la taille des amas de lacunes présents dans ladite partie du substrat donneur à ladite première densité.

24. Substrat semi-conducteur sur isolant comportant une couche isolante intercalée entre une couche mince de matériau semi-conducteur et un substrat support, obtenu par le procédé selon l'une quelconque des revendications précédentes à partir d'un substrat donneur présentant une densité d'amas de lacunes sensiblement égale à 3/cm², **caractérisé en ce que** la couche mince comporte une densité d'amas de lacunes sensiblement inférieure ou égale à 0,075/cm².

25. Substrat selon la revendication précédente, **caractérisé en ce que** le substrat support comporte une densité d'amas de lacunes sensiblement supérieure ou égale à 3/cm ².

26. Procédé de recyclage d'un substrat présentant des amas de lacunes et ayant servi de substrat donneur pour le prélèvement et le transfert d'une couche mince sur un substrat support, **caractérisé en ce qu'**il consiste en une ou plusieurs étapes adaptées pour ne pas venir augmenter la taille des amas de lacunes présents dans ledit substrat.
